# EUROPEAN PATENT SPECIFICATION

(11) **EP 0 365 263 B1**
(45) Date of publication and mention of the grant of the patent: **26.02.1997**
(21) Application number: 89310619.5
(22) Date of filing: 17.10.1989
(51) Int. Cl.: G03F 7/00, G01P 1/08

(54) **Display board and method for producing the same**
Anzeigetafel und Herstellungsverfahren
Tableau d'affichage et procédé de fabrication

(30) Priority: 18.10.1988 JP 262181/88; 18.10.1988 JP 262182/88; 27.06.1989 JP 164520/89; 06.10.1989 JP 262535/89
(43) Date of publication of application: 25.04.1990
(73) Proprietor: NIPPONDENSO CO., LTD., Kariya-city Aichi-pref., 448 (JP)
(72) Inventor: Iwase,Teruhiko, Aichi-ken (JP); Imai, Takeshi, Obu-shi, Aichi-ken (JP); Koura, Toshio, Aichi-ken (JP)
(74) Representative: Dempster, Benjamin John Naftel

(56) References cited:
- EP-A- 0 182 031
- DE-A- 3 342 681
- DE-A- 3 704 574
- DE-A- 3 720 726
- GB-A- 625 425
- US-A- 4 304 837
- PATENT ABSTRACTS OF JAPAN, vol. 12, no. 372 (P-767)(3217) 5 October 1988; & JP-A-63 121 046

## Description

The present invention relates to a display board by which voluntary colored picture is formed on a substrate. Such a display board is used as a dial board of a tachometer and a speed meter of a vehicle, for example.

Letters, figures or the like on a dial board of a meter are conventionally formed on a resin substrate by printing, especially by screen printing. The screen printing enables the printing of a thick paint film to provide a deep picture.

However, the above screen printing uses liquid ink diluted by solvent, causing the contamination of working environment, and fire due to the evaporation of the solvent within the ink, requiring time for removing ink from a printing plate clogged therewith and controlling the viscosity of ink, and requiring skill in controlling these operations.

Accordingly, recently, a photopolymerization ink containing no solvent and setting in a short time has been proposed. This photopolymerization ink takes advantage of the photosetting property of the photopolymerization resin. It has low viscosity and high fluidity before light irradiation so as not to need any solvent.

However, this photopolymerization ink requires the addition of reactant type diluent(for a monomer of low molecular weight) in order to adjust the viscosity thereof so as to be suited to the screen printing. This diluent functions similarly to the solvent so that unreacted substance gradually evaporates from the paint film. Moreover, the photopolymerization ink is of a low molecular weight as a whole thus having problems of a large scaled shrinkage due to setting, shortage of adhesion, or lack of flexibility. In addition, the production cost is expensive so that the photopolymerization ink is insufficient in practical use.

Moreover, multicolor printing has been desired in order to improve the appearance of the dial board, and the visibility thereof. In order to satisfy the above desire, the conventional screen printing requires printing plates and inks of the same number as that of colors. This results in the troublesome producing processes and increased production cost.

Meanwhile, offset printing has mainly been adopted as the multicolor printing in the printing trade. However, in applying this offset printing to a display board, this offset printing has also probelms that ink is liquid, or the color density of each printing plate is insufficient.

It is an object of the present invention to provide a display board which is capable of displaying a picture of excellent quality with voluntary colours, and a method for producing such a display board without using any solvent or reactant type diluent with the improvement of the working environment and the work efficiency.

According to one aspect of the present invention there is provided a display board comprising:
a receiver base (1, 31);
a first coloured photopolymerised resin layer (32) including a first colouring agent of a first colour, which is directly laminated on a surface of said receiver base to form a first picture pattern in said first colour; and
a second coloured photopolymerised resin layer (33) including a second colouring agent of a second colour, said second coloured photopolymerised resin layer being directly laminated both on at least a portion of said surface of said receiver base (1, 31) on which said first picture pattern is not formed, and on at least a portion of a surface of said first coloured photopolymerised resin layer (32), to form a second picture pattern on said at least a portion of said surface of said receiver base (1, 31) and on said at least a portion of said surface of said first coloured photopolymerised resin layer (32),
whereby a two-dimensional non-flat display including said first and second picture patterns is formed with said second picture pattern being on at least two levels thereof with respect to the receiver base.

The method according to the present invention does not require the formation of the conventional printing plates, and the preparation of ink, and accordingly is free from such problems as the troublesome viscosity control of ink, contamination of the working environment due to the evaporation of the solvent, and clogging of the printing plates . Moreover, by forming the photopolymerization resin layer into a film shape, the handling thereof is facilitated as well as the control of operations, and the automation of the production processes.
Figs. 1 to 8 illustrate a first embodiment of the present invention;
Fig. 1 is a partially enlarged cross-sectional view of a dial board of a tachometer for a vehicle, to which the first embodiment is applied;
Fig. 2 is a front view of the dial board;
Fig. 3 is an enlarged cross-sectional view of a photopolymerization resin film for the formation of a picture layer.
Figs. 4(1) to 4(12) are views showing the production processes of the dial board;
Figs. 5 and 6 are partially enlarged cross-sectional views of a boundary of a picture layer of the dial board;
Fig. 7 is a view showing the relation between the setting degree of the colored photopolymerization resin and the picture quality;
Fig. 8 is a view showing the relation between the setting degree and the film hardness;
Figs. 9 and 10 illustrate a second embodiment of the present invention;

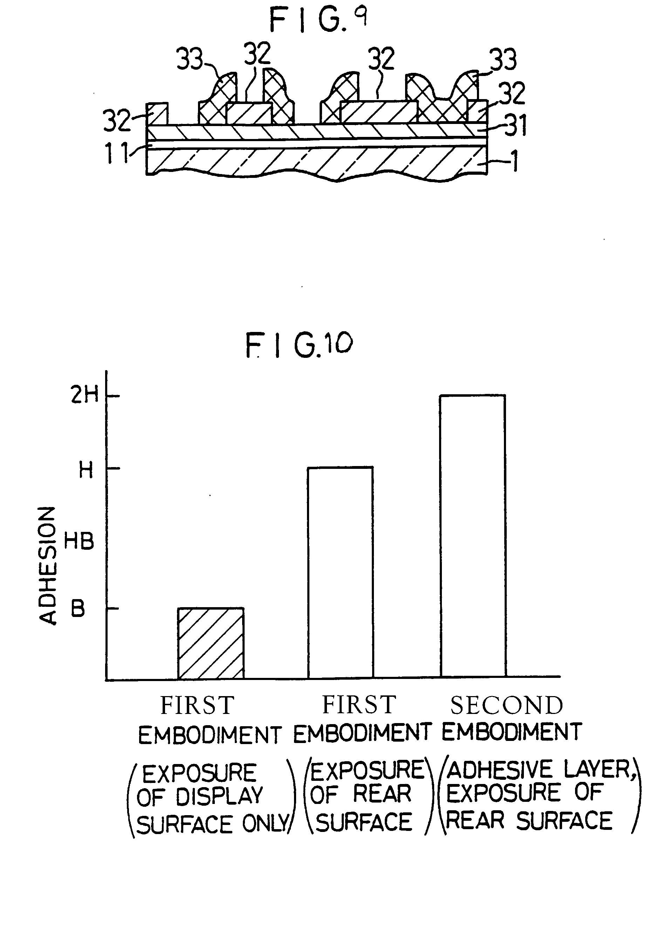

Fig. 9 is a partially enlarged cross-sectional view of a display board;
Fig. 10 is a view showing the adhesion improvement effect obtained in the third embodiment;

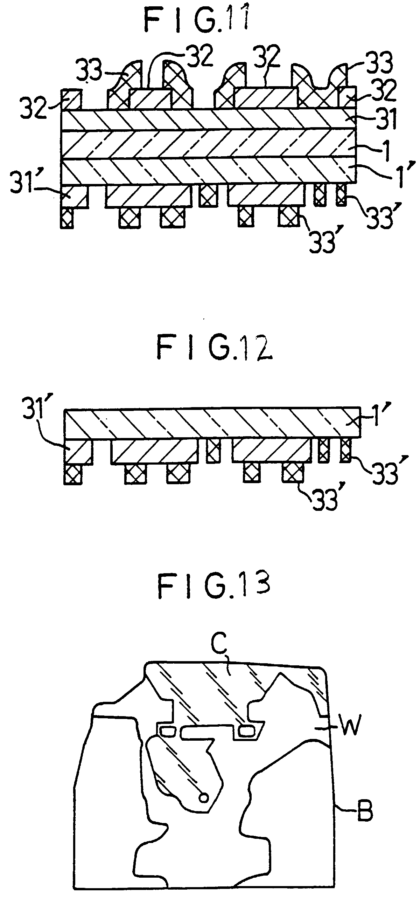

Figs. 11 and 12 illustrate a fourth embodiment of the present invention;
Fig. 11 is a partially enlarged cross-sectional view of a display board;
Fig. 12 is a partially enlarged cross-sectional view of a picture for controlling the amount of the transmitted light;
Fig. 13 is a front view of the picture for controlling the amount of the transmitted light; and

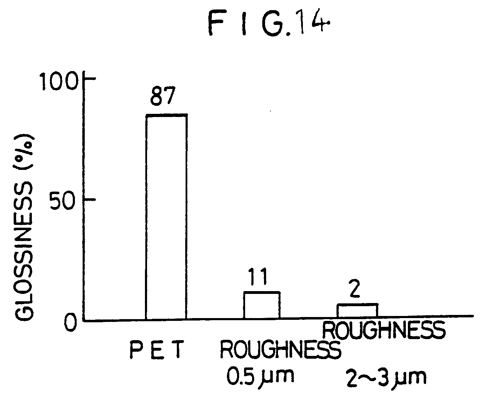

Fig. 14 is a view showing the relation between the roughness of a transparent supporting member and the glossiness of a picture layer.

Hereinafter, the present invention will be explained in accordance with the embodiments with reference to the drawings.

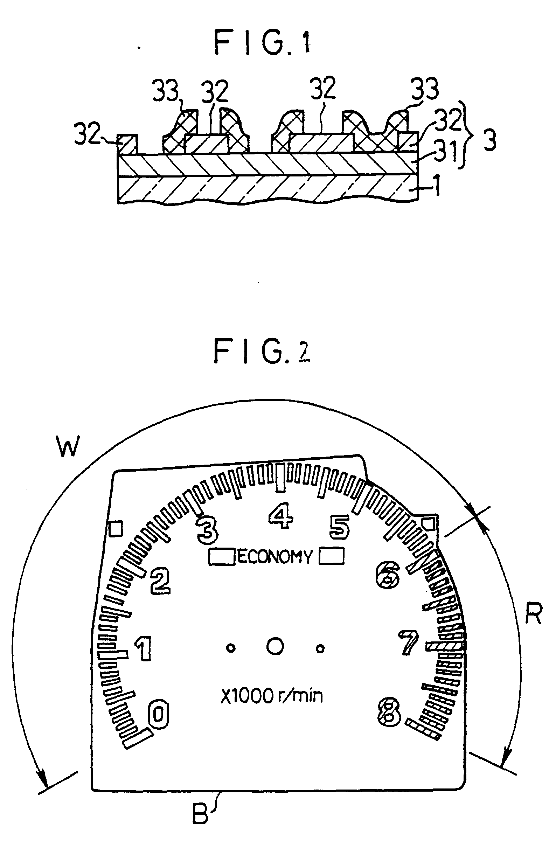

Figs. 1, 2 and 3 illustrate a first embodiment wherein the present invention is applied to a dial board of a tachometer for a vehicle. In this embodiment, the picture layer is formed by successively laminating colored photopolymerization resin films, each having a predetermined picture pattern, in place of using a compound layer of dots-shaped photopolymerization resins. And the figures, scales and letters in the region W of 0 to 6 are colored white while those in the region R of 6 to 8 are colored red, for example. The background except for these figures and scales is colored black.

Fig. 1 is a partially enlarged cross-sectional view of Fig. 2. A white picture layer 31 is formed on the substrate 1 made of transparent resin so as to cover the entire surface thereof. And a red picture layer 32 made of red photopolymerization resin is formed on the white picture layer 31 thereby forming the picture pattern corresponding to the figures and scales of the region R of Fig. 2. On the red picture layer 32 is formed a black picture layer 33 made of black photopolymerization resin, which corresponds to the background B. These picture layers 31, 32 and 33 compose the picture layer 3.

The above-described dial board is produced as follows:

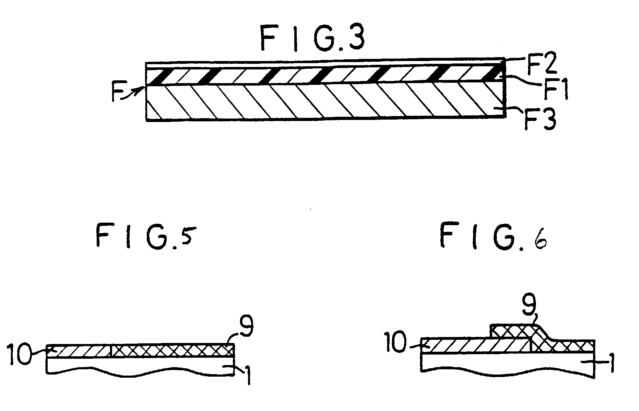

Each of the picture layers 31, 32 and 33 can be made of the colored photopolymerization resin film F shown in Fig. 3.

In Fig. 3, a colored photopolymerization resin layer F1 is formed on a support member F3. The surface of the colored photopolymerization resin layer F1 is protected by a protective film F2.

The colored photopolymerization resin layer F1 contains a coloring agent such as pigment, or dye, photopolymerization resin(molecular weight: tens to thousands), binder polymer(molecular weight:tens of thousands to hundreds of thousands), catalyst(photopolymerization initiator), and auxiliary agent(polymerization inhibitor). By voluntarily selecting the coloring agent, the layer F1 is colored yellow, magenta, cyan or black.

The density of each color is set as follows in accordance with the density range of ink for screen printing of a dial board.

| | |
|---|---|
| yellow-based ink | 0.1 to 0.6 |
| magenta-based ink | 0.2 to 0.7 |
| cyan-based ink | 0.3 to 1.0 |
| black-based ink | 0.8 to 3.5 |

The density of each color is measured by using a transmission density meter made by Dainihon Screen Co., Ltd. with setting the clear 0 without using any filter.

Examples of the photopolymerization resin are urethane acrylate, epoxy acrylate, or polyol acrylate . Especially, urethane acrylate is preferably used. And acryl-based polymer has a film property and an adhesion property suitable to the binder polymer.

The transparent photopolymerization resin layer F2 has a composition substantially equal to that of the colored photopolymerization resin layer F1 except for no pigment being included.

The support member F3 supports the colored photopolymerization resin layer F1 until being transferred to the transparent photopolymerization resin layer F2. The material for the support member F3 is desired to be easily peeled off the layer F1. Examples of such a material are polyethylene terephthalate, polypropylene, polyethylene, polyvinyl alcohol, and polyvinyl chloride. The thickness of the support member F3 is ordinarily 10 to 150 µm, preferably 20 to 50 µm.

The material for the protective film F2 is desired to be easily peeled off the layer F1, and to have a good light transmission property in order to expose the colored photopolymerization resin layer F1 therethrough. The preferable examples of such a material are polyetylene and polypropylene. The preferable thickness thereof is ordinarily 10 to 50 µm.

In the first embodiment, the thickness of the colored photopolymerization resin layer F1 composing the picture layer is ordinarily 5 to 50 µm, preferably 10 to 15 µm in consideration of the visibility, appearance, or color density.

And the transparent support member F3 is desired to have good light transmission property in order to expose the colored photopolymerization resin layer F1 therethrough.

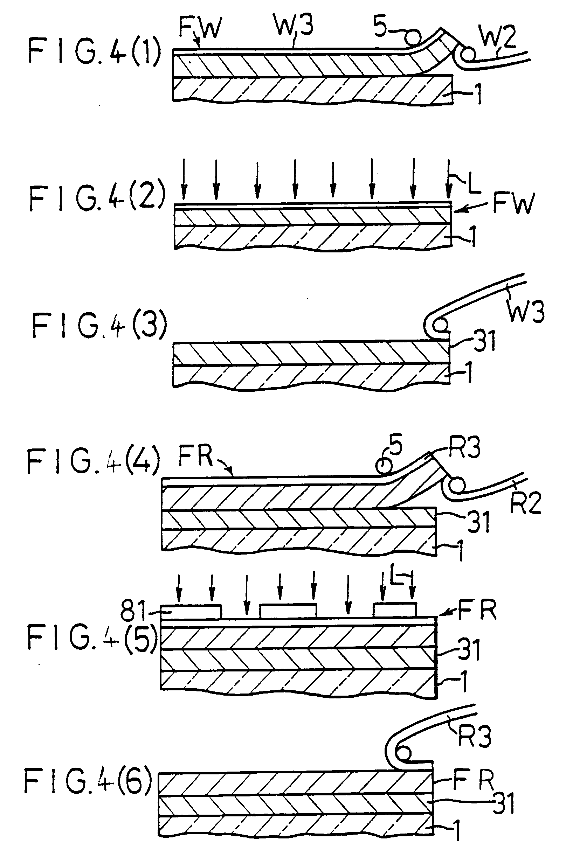

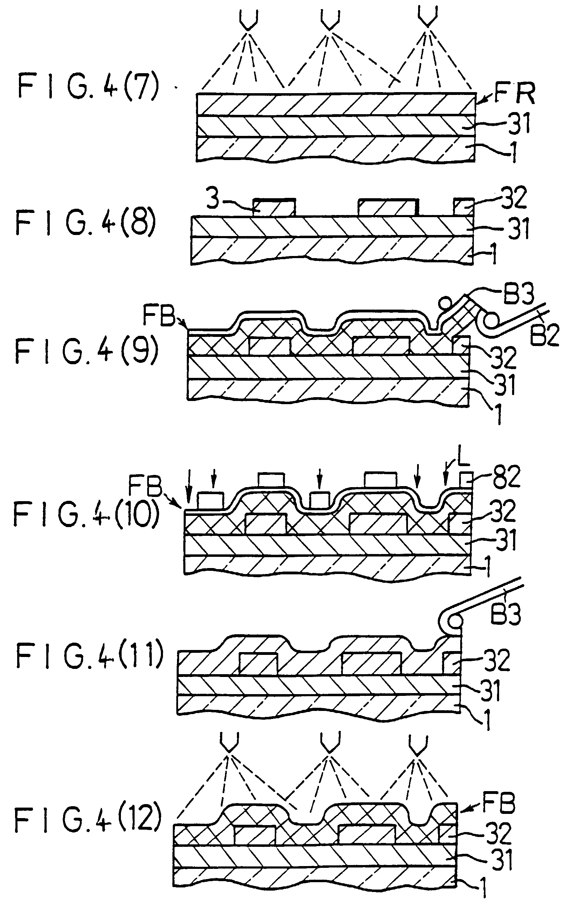

The photopolymerization resin films FW, FR, FB of white, red and black, each having the above-described construction were prepared, and a display board is produced in the processes shown in Figs. 4 (1) to 4 (12).

Firstly, in the process shown in Fig. 4 (1), the white polymerization resin film FW is pasted on the substrate 1(thickness: about 0.5 to 1.5 mm) and is made to pressure-adhere thereto by means o the laminater 5 while peeling a protective film W2 off the film FW.

Next, in the process shown in Fig. 4 (2), the film FW is irradiated with active energy rays such as ultraviolet rays L to be exposed and set. The exposure is performed by means of an ultra high pressure mercury lamp, and the amount of exposure is preferably 200 to 500mJ/cm² for white. Then, the transparent support layer W3 is peeled(Process of Fig. 4(3)) thereby forming the white picture layer 31 (transmission intensity: 0.8 to 1.0) on the substrate 1.

In the process shown in Fig. 4 (4), the red photopolymerization resin film FR is made to pressure-adhere to the white picture layer 31 while peeling a protective film R2. On this red polymerization resin film FR is placed a negative mask 81 corresponding to the region R of Fig. 2, and is contact-exposed(Process of Fig. 4(5)). Then, a transparent supporting layer R3 is peeled off the film FR(Process of Fig. 4(6)). The amount of exposure is preferably 200 to 500 mJ/cm².

In the process shown in Fig. 4 (7), the wet development by using alkali or solvent, or the dry development is performed to remove unexposed portions from the film FR. This results in only the portions which are reacted to light so as to firmly adhere and be set, remaining thereby forming the red picture layer 32 corresponding to the figures and scales of the region R on the white picture layer 31 with the transmission density of 0.4 to 0.7).

Next, in order to form the figures, scales or the like of the region W, and display them sharply as well as to give them the function as the transmission type display board, black photopolymerization resin film FB is subjected to similar processes.

In the process shown in Fig. 4(9), the black photopolymerization resin film FB is made to pressure-adhere to the red picture layer 32 while peeling a protective film B2. And in the process shown in Fig. 4 (10), a negative mask 82 is placed on the film FB, and contact-exposure is performed. The preferable amount of exposure is about 1000 mJ/cm².

Then, the transparent support layer B3 is peeled off the film FB(Process of Fig. 4(11)), and the development is performed(Process of Fig. 4 (12)) to form a black picture layer 33 having a transmission density of 4 or more. Thus, the display board having the construction shown in Figs. 1 and 2 is obtained.

By forming a masking picture layer having a large transmission density, such as the black picture layer 33, the obtained picture is observed as the reflection type picture in the daytime. In the nighttime, by placing a light source on the rear side of the substrate, the figures and letters transmit light to shine with various colors while the black background portion does not transmit light so that this construction can be used as the transmisiion type picture and illumination. In this case, it is preferable to use the masking picture layer having a transmission density of 2.0 or more.

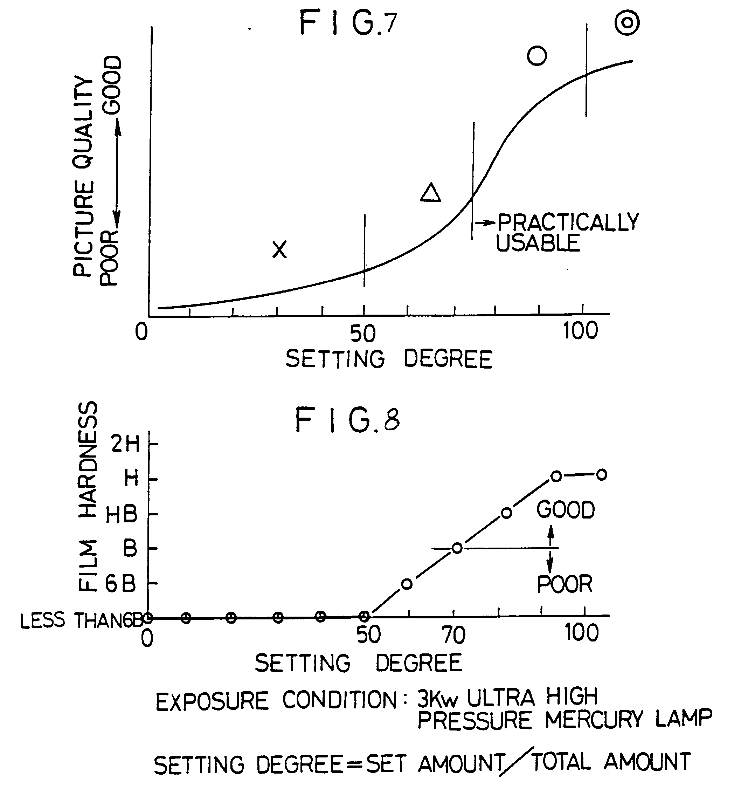

And a masking picture layer 9 may be arranged in contact with another picture layer 10 as shown in Fig. 5 Instead, an edge of the masking picture layer 9 may be laminated on another picture layer 10 as shown in Fig. 6. This construction enables the formation of a jointless beautiful picture.

When the photopolymerization resin is colored, the setting degree tends to be slightly lowered. But when the colored photopolymerization resin for the picture layer of the present invention has a setting degree of about 70% or more, the picture layer is not affected by remaining unreacted substances.

The present inventors' examination shows that the setting degree of the colored photopolymerization resin, and the picture quantity have such relations to each other as shown in Fig. 7. The picture quality implies the color maintaining force, light resistance, adhesion property to the substrate, film hardness, heat resistance, and heat cycle resistance. At the setting degree of 70% or more, practically usuable picture quality can be obtained.

Picture layers, each having different setting degrees, were prepared from the colored photopolymerization resins having a thickness of 10 to 15 µm and a transmission density of about 1.3 in the thickness of 15 µm by varying the amount of exposure. The relation between the setting degree and the film thickness is shown in Fig. 8. And the prepared picture layers having setting degrees of 50%, 70%, and 100%, respectively, were subjected to the durability test under the conditions shown in Table 1. The evaluation was performed as follows: Namely, when all of the checking items are satisfied, the mark ○ is inserted, and otherwise, the mark X is inserted in Table 1. As is apparent from Table 1, at the setting degree of about 70 % or more, such high picture quality as to be sufficienly durable to long use can be obtained. Moreover, by adjusting the film thickness, color intensity, or amount of exposure, 100% of setting degree can be obtained.

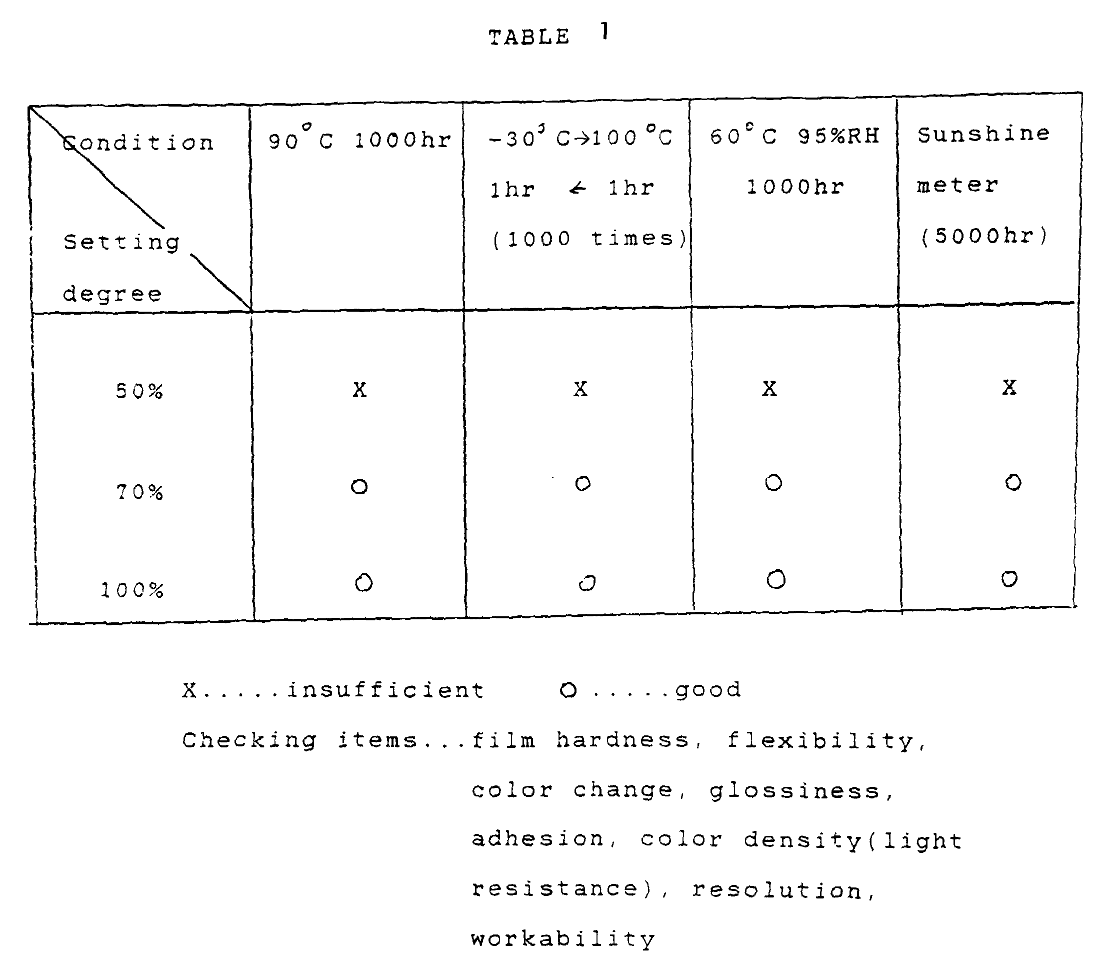

When the substrate has light transmission property like that of the present embodiment, the setting degree can be further improved by exposing the previously formed picture layer from the rear surface of the substrate again. In this case, unreacted portions of the photopolymerizaton resin are reduced, and accordingly the setting degree is improved.

Fig. 9 illustrates a second embodiment of the present invention. In this embodiment, an adhesive layer 11 made of transparent photopolymerizaton resin is provided between the substrate 1 and the undermost picture layer(in this embodiment, the white picture layer 31). The other construction of the second embodiment is similar to that of the first embodiment. The adhesive layer 11 is transparent and does not include any dye or pigment so as to exhibit high setting degree as compared with the colored one whereby high adhesion of the picture layer and the substrate can be obtained. By exposing the substrate of the construction of the second embodiment from the rear surface thereof again, the adhesion of the picture layer and the substrate can be much improved. Accordingly, a display board which is excellent in the working resistance in drilling and assembling in a display panel, is obtained. The thickness of the adhesive layer 11 is ordinarly about 0.1 to 100 µm, and preferably about 5 to 10 µm.

Fig. 10 shows the result of the scratch test of the sample of the second embodiment by means of pencils of various hardness. In addition, the test results of the samples of the first embodiment, each being exposed in only the display surface thereof or in both display surface and rear surface thereof, are also shown for comparison. The test result shows that the samples of the first embodiment exhibit hardness(adhesion) good enough to be practically used, and by also exposing the rear surface and providing the adhesive layer in the second embodiment, the hardness(adhesion) is drastically improved.

Fig 11 illustrates a third embodiment of the present invention. In the present embodiment, in order to adjust the amount of transmitting light, another picture layer shown in Fig. 12 is further laminated on a rear surface of the dial board of the tachometer for a vehicle shown in Figs. 1 and 2. This construction prevents the lightness of the displayed picture from lacking uniformity due to the light source disposed on the rear side of the display board.

In Fig. 12, the picture adapted for adjusting the amount of transmitting light is formed by successively forming a white picture layer 31' and a black picture layer 33′, each having a predetermined pattern, on an under surface of a substrate 1′ made of transparent resin so as to have a picture pattern as shown in Fig. 13, for example. In the drawing, the region B corresponds to the black picture layer while the region W corresponds to the white picture layer. The light source is disposed at a nearly central portion of the region B. The masking property is gradually decreased as the distance from the light source is increased. The picture layer is not formed in the region C which is comparatively remote from the light source. In the region C, the transparent substrate is exposed to the outside. This picture pattern is voluntarily changed in consideration of the lightness, and position of the light source.

The display board having the above described construction is produced as follows: Picture layers 31, 32, and 33 are previously formed on the substrate 1 while picture layers 31', 33' are previously formed on the substrate 1′, and then, the substrates 1, 1′ on which the picture layers are formed, respectively, are exposed again from the respective rear surfaces thereof to improve the hardness thereof. By further providing the adhesive layer shown in the second embodiment, the adhesion can be much improved. Thereafter, the substrates 1, 1′ are pasted or secured to each other by means of bolts or the like so as to come into close contact with each other.

As described above, in accordance with the present invention, the display board may be composed by laminating a plurality of substrates on each of which desired picture layers are formed. In this case, the displayed picture can be made different between the reflection type display board and the transmission type display board. For example, by disposing a decorative picture as the background between the letter picture and the light amount adjusting picture, in the daytime, only the uppermost letter picture is perceived while at the time the light source is lighted up, the decorative picture is added to the letter picture to increase the decorativeness of the display board.

Moreover, in accordance with the present invention, the frosted picture can be obtained by roughing the surface of the picture layer to reduce the glossiness thereof. This frosted picture prevents the surface of the reflection type picture from shining, and give the picture quiet tone of color. The frosted picture can be realized by previously roughing the surface of the colored photopolymerization resin film, which is to come in contact with the colored photopolymerization resin layer of the transparent support member, or roughing the surface of the formed picture layer by hot pressing. For instance, by varying the roughness of the transparent supporting member made of polyethylene terephthalate(PET), the glossiness of the surface of the picture layer can be reduced from 87% to 11%(roughness of the transparent support member:0.5 µm) or 2% (roughness of the transparent support member:2 to 3 µm).

In the preceding first to third embodiments, the picture is composed of three colors, white, red and black. In accordance with the present invention, the colors for composing the picture are not limited to these three colors. A plurality of films, each having a desired color can be voluntarily combined with each other. When the display board is not of transmission type, it is unnecessary to compose the substrate of transparent resin. Colored resin will do.

## Claims

1. A display board comprising:
a receiver base (1,31);
a first coloured photopolymerised resin layer (32) including a first colouring agent of a first colour, which is directly laminated on a surface of said receiver base to form a first picture pattern in said first colour; and
a second coloured photopolymerised resin layer (33) including a second colouring agent of a second colour, said second coloured photopolymerised resin layer (33) being directly laminated both on at least a portion of said surface of said receiver base (1,31) on which said first picture pattern is not formed, and on at least a portion of a surface of said first coloured photopolymerised resin layer (32), to form a second picture pattern on said at least a portion of said surface of said receiver base (1, 31) and on said at least a portion of said surface of said first coloured photopolymerised resin layer (32),
whereby a two-dimensional non-flat display including said first and second picture patterns is formed with said second picture pattern being on at least two levels thereof with respect to the receiver base.

2. The display board according to claim 1, wherein said receiver base (1,31) includes a first part (1) composed of a transparent resin, and a third coloured photopolymerised resin layer on said transparent resin, and said first coloured photopolymerised resin layer (32) has an adhesion region which adheres to said third coloured photopolymerised resin film (31).

3. The display board according to claim I or claim 2, wherein each of said first coloured photopolymerised resin layer (32) and said second coloured photopolymerised resin layer (33) has a thickness of between 5 and 50 µm.

4. The display board according to claim 1, 2 or 3, wherein each of said first coloured photopolymerised resin layer (32) and said second coloured photopolymerised resin layer (33) includes a support member (B3,R3) to which it is attached prior to being laminated on said surface of said receiver base (1,31), thereby to increase the strength of each of said first coloured photopolymerised resin layer (32) and said second coloured photopolymerised resin layer (33).

5. The display board according to any preceding claim, wherein said receiver base (1,31) includes a third coloured photopolymerised resin layer (31) which is totally exposed and photopolymerised, and coloured with a third colour different from said first colour and said second colour, and said first coloured photopolymerised resin layer (32) is directly adhered to said third coloured photopolymerised resin layer (31).

6. The combination of display board according to any preceding claim and a light source for illuminating light to said receiver base (1,31) from a side where said first coloured photopolymerised resin layer (32) is not provided.

7. A method of forming a display board comprising the steps of:
1) directly affixing a first coloured photopolymerisable resin layer (32) of a first colour on a surface of a receiver base (1,31);
2) exposing said first coloured resin layer (32) through a negative (81) having a first picture pattern, to provide exposed portions and unexposed portions in said first coloured resin layer (32);
3) removing said unexposed portions by wet development to directly form said first picture pattern of said first colour, which includes said first coloured resin layer (32);
4) directly affixing a second coloured photopolymerisable resin layer (33) of a second colour different than said first colour, both on at least a portion of said surface of said receiver base (1,31) on which said first picture pattern is not formed and on at least a portion of said first coloured resin layer (32), and exposing said second resin layer through a negative (82) of a second picture pattern to form exposed portions and unexposed portions of said second resin layer; and
5) removing said unexposed portions in said second coloured resin layer (33) by wet development to directly form said second picture pattern of said second colour, which is composed of said second coloured resin layer (33), on both said at least a portion of said receiver base (1,31) and said at least a portion of said first coloured resin layer (32) to form a two-dimensional non-flat display including said first and second picture patterns, with said second picture pattern on at least two levels thereof with respect to the receiver base.

8. The method according to claim 7, wherein each of said first coloured resin layer (32) and said second coloured resin layer (33) has a thickness of 5 to 50 µm.

9. The method according to claim 7 or claim 8, wherein each of said first coloured resin layer (32) and said second coloured resin layer (33) is supported by a support member (B3,R3) prior to being directly affixed on said surface of said receiver base for increasing the strength of each of said first coloured resin layer (32) and said second coloured resin layer (33).

10. The method according to claim 7, 8 or 9, wherein a surface of said support member (B3,R3), which is to come into contact with each of said first coloured resin layer (32) and said second coloured resin layer (33) has good light transmission properties in order to expose the coloured photopolymerised layer therethrough.

## Patentansprüche

1. Anzeigetafel, die aufweist:
einen Aufnahmeträger (1, 31);
eine ein erstes Färbemittel einer ersten Farbe beinhaltende erste farbige photopolymerisierte Harzschicht (32), welche direkt auf eine Oberfläche des Aufnahmeträgers geschichtet ist, um ein erstes Bildmuster in der ersten Farbe auszubilden; und
eine ein zweites Färbemittel einer zweiten Farbe beinhaltende zweite farbige photopolymerisierte Harzschicht (33), wobei die zweite farbige photopolymerisierte Harzschicht (33) direkt sowohl auf mindestens einen Abschnitt der Oberfläche des Aufnahmeträgers (1, 31), auf welchem das erste Bildmuster nicht ausgebildet ist, als auch auf mindestens einen Abschnitt einer Oberfläche der ersten farbigen photopolymerisierten Harzschicht (32) geschichtet ist, um auf mindestens einem Abschnitt der Oberfläche des Aufnahmeträgers (1, 31) und auf mindestens einem Abschnitt der Oberfläche der ersten farbigen photopolymerisierten Harzschicht (32) ein zweites Bildmuster auszubilden,
wodurch eine zweidimensionale unebene Anzeige ausgebildet ist, die die ersten und zweiten Bildmuster beinhaltet, wobei sich das zweite Bildmuster auf mindestens zwei Höhen von dieser bezüglich des Aufnahmeträgers befindet.

2. Anzeigetafel nach Anspruch 1, bei der der Aufnahmeträger (1, 31) ein erstes Teil (1), das aus einem transparententen Harz besteht, und eine dritte farbige photopolymerisierte Harzschicht auf dem transparenten Harz beinhaltet und die erste farbige photopolymerisierte Harzschicht (32) einen Adhäsionsbereich aufweist, welcher an dem dritten farbigen photopolymerisierten Harzfilm (31) haftet.

3. Anzeigetafel nach Anspruch 1 oder Anspruch 2, bei der sowohl die erste farbige photopolymerisierte Harzschicht (32) als auch die zweite farbige photopolymerisierte Harzschicht (33) eine Dicke zwischen 5 und 50 µm aufweist.

4. Anzeigetafel nach Anspruch 1, 2 oder 3, bei der sowohl die erste farbige photopolymerisierte Harzschicht (32) als auch die zweite farbige photopolymerisierte Harzschicht (33) ein Trägerteil (B3, R3) beinhaltet, an welchem sie angebracht wird, bevor sie auf die Oberfläche des Aufnahmeträgers (1, 31) geschichtet wird, um dadurch die Stärke sowohl der ersten farbigen photopolymerisierten Harzschicht (32) als auch der zweiten farbigen photopolymerisierten Harzschicht (33) zu erhöhen.

5. Anzeigetafel nach einem der vorhergehenden Ansprüche, bei der der Aufnahmeträger (1, 31) eine dritte farbige photopolymerisierte Harzschicht (31) beinhaltet, welche vollständig belichtet und photopolymerisiert ist und mit einer dritten Farbe gefärbt ist, die zu der ersten Farbe und der zweiten Farbe unterschiedlich ist, und die erste farbige photopolymerisierte Harzschicht (32) direkt an der dritten farbigen photopolymerisierten Harzschicht (31) haftet.

6. Kombination einer Anzeigetafel nach einem der vorhergehenden Ansprüche und einer Lichtquelle zum Strahlen von Licht zu dem Aufnahmeträger (1, 31) von einer Seite, an der die erste farbige photopolymerisierte Harzschicht (32) nicht vorgesehen ist.

7. Verfahren zum Ausbilden einer Anzeigetafel, das die folgenden Schritte aufweist:
**1)** direktes Anbringen einer ersten farbigen photopolymerisierbaren Harzschicht (32) einer ersten Farbe auf einer Oberfläche eines Aufnahmeträgers (1,31);
**2)** Belichten der ersten farbigen Harzschicht (32) durch ein Negativ (81), das ein erstes Bildmuster aufweist, um belichtete Abschnitte und unbelichtete Abschnitte in der ersten farbigen Harzschicht (32) vorzusehen;
**3)** Entfernen der unbelichteten Abschnitte durch Naßentwickeln, um direkt das erste Bildmuster der ersten Farbe auszubilden, welches die erste farbige Harzschicht (32) beinhaltet;
**4)** direktes Anbringen einer zweiten farbigen photopolymerisierbaren Harzschicht (32) einer zweiten Farbe, die zu der ersten Farbe unterschiedlich ist, sowohl auf mindestens einem Abschnitt der Oberfläche des Aufnahmeträgers (1, 31), auf welchem das erste Bildmuster nicht ausgebildet ist, als auch auf mindestens einem Abschnitt der ersten farbigen Harzschicht (32) und Belichten der zweiten Harzschicht durch ein Negativ (82) eines zweiten Bildmusters, um belichtete Abschnitte und unbelichtete Abschnitte der zweiten Harzschicht auszubilden; und
**5)** Entfernen der unbelichteten Abschnitte in der zweiten farbigen Harzschicht (33) durch Naßentwickeln, um direkt das zweite Bildmuster der zweiten Farbe auszubilden, welches aus der zweiten farbigen Harzschicht auf sowohl mindestens einem Abschnitt des Aufnahmeträgers (1, 31) als auch auf mindestens einem Abschnitt der ersten farbigen Harzschicht (32) besteht, um eine zweidimensionale unebene Anzeige auszubilden, die die ersten und zweiten Bildmuster beinhaltet, wobei sich das zweite Bildmuster auf mindestens zwei Höhen von dieser bezüglich des Aufnahmeträgers befindet.

8. Verfahren nach Anspruch 7, bei dem sowohl die erste farbige Harzschicht (32) als auch die zweite farbige Harzschicht (33) eine Dicke von 5 bis 50 µm aufweist.

9. Verfahren nach Anspruch 7 oder Anspruch 8, bei dem sowohl die erste farbige Harzschicht (32) als auch die zweite farbige Harzschicht (33) zum Erhöhen der Stärke sowohl der ersten farbigen Harzschicht (32) als auch der zweiten farbigen Harzschicht (33) durch ein Trägerteil (B3, R3) gehalten werden, bevor sie direkt auf der Oberfläche des Aufnahmeträgers angebracht werden.

10. Verfahren nach Anspruch 7, 8 oder 9, bei dem eine Oberfläche des Trägerteils (B3, R3), welche sowohl mit der ersten farbigen Harzschicht (32) als auch mit der zweiten farbigen Harzschicht (33) in Kontakt kommt, gute Lichtdurchlaßeigenschaften aufweist, um dadurch die farbige photopolymerisierte Schicht zu belichten.

## Revendications

1. Panneau d'affichage comprenant :
une base réceptrice (1, 31),
une première couche de résine photopolymérisée colorée (32) comprenant un premier agent colorant d'une première couleur, qui est stratifié directement sur une surface de ladite base réceptrice afin de former un premier motif d'image dans ladite première couleur, et
une seconde couche de résine photopolymérisée colorée (33) comprenant un second agent colorant d'une seconde couleur, ladite seconde couche de résine photopolymérisée colorée (33) étant stratifiée directement à la fois sur au moins une partie de ladite surface de ladite base réceptrice (1, 31) sur laquelle ledit premier motif d'image n'est pas formé, et sur au moins une partie d'une surface de ladite première couche de résine photopolymérisée colorée (32), afin de former un second motif d'image sur ladite au moins une partie de ladite surface de ladite base réceptrice (1, 31) et sur ladite au moins une partie de ladite surface de ladite première couche de résine photopolymérisée colorée (32),
d'où il résulte que l'on forme un affichage en relief bidimensionnel comprenant lesdits premier et second motifs d'image, ledit second motif d'image étant sur au moins deux niveaux de celui-ci par rapport à la base réceptrice.

2. Panneau d'affichage selon la revendication 1, dans lequel ladite base réceptrice (1, 31) comprend une première partie (1) composée de résine transparente, et une troisième couche de résine photopolymérisée colorée sur ladite résine transparente, et ladite première couche de résine photopolymérisée colorée (32) présente une région d'adhérence qui adhère audit troisième film de résine photopolymérisée coloré (31).

3. Panneau d'affichage selon la revendication 1 ou la revendication 2, dans lequel chacune de ladite première couche de résine photopolymérisée colorée (32) et de ladite seconde couche de résine photopolymérisée colorée (33) présente une épaisseur entre 5 et 50 µm.

4. Panneau d'affichage selon la revendication 1, 2 ou 3, dans lequel chacune de ladite première couche de résine photopolymérisée colorée (32) et de ladite seconde couche de résine photopolymérisée colorée (33) comprend un élément de support (B3, R3) auquel elle est fixée avant d'être stratifiée sur ladite surface de ladite base réceptrice (1, 31) afin d'augmenter ainsi la résistance de chacune de ladite première couche de résine photopolymérisée colorée (32) et de ladite seconde couche de résine photopolymérisée colorée (33).

5. Panneau d'affichage selon l'une quelconque des revendications précédentes, dans lequel ladite base réceptrice (1, 31) comprend une troisième couche de résine photopolymérisée colorée (31) qui est totalement exposée et photopolymérisée, et colorée d'une troisième couleur qui diffère de ladite première couleur et de ladite seconde couleur, et ladite première couche de résine photopolymérisée colorée (32) adhère directement à ladite troisième couche de résine photopolymérisée colorée (31).

6. Combinaison du panneau d'affichage selon l'une quelconque des revendications précédentes et d'une source de lumière destinée à illuminer avec de la lumière ladite base réceptrice (1, 31) depuis un côté où ladite première couche de résine photopolymérisée colorée (32) n'est pas prévue.

7. Procédé de formation d'un panneau d'affichage comprenant les étapes consistant à :
1) fixer directement une première couche de résine photopolymérisable colorée (32) d'une première couleur sur une surface d'une base réceptrice (1, 31),
2) exposer ladite première couche de résine colorée (32) au travers d'un négatif (81) présentant un premier motif d'image, afin de procurer des parties exposées et des parties non exposées dans ladite première couche de résine colorée (32),
3) éliminer lesdites parties non exposées par développement humide afin de former directement ledit premier motif d'image de ladite première couleur, qui comprend ladite première couche de résine colorée (32),
4) fixer directement une seconde couche de résine photopolymérisable colorée (33) d'une seconde couleur qui diffère de ladite première couleur, à la fois sur au moins une partie de ladite surface de ladite base réceptrice (1, 31) sur laquelle ledit premier motif d'image n'est pas formé, et sur au moins une partie de ladite première couche de résine colorée (32), et exposer ladite seconde couche de résine au travers d'un négatif (82) d'un second motif d'image afin de former des parties exposées et des parties non exposées de ladite seconde couche de résine, et
5) éliminer lesdites parties non exposées dans ladite seconde couche de résine colorée (33) par développement humide afin de former directement ledit second motif d'image de ladite seconde couleur, qui est composé de ladite seconde couche de résine colorée (33), à la fois sur ladite au moins une partie de ladite base réceptrice (1, 31) et ladite au moins une partie de ladite première couche de résine colorée (32) afin de former un affichage en relief bidimensionnel comprenant lesdits premier et second motifs d'image, ledit second motif d'image étant sur au moins deux niveaux de celui-ci par rapport à la base réceptrice.

8. Procédé selon la revendication 7, dans lequel chacune de ladite première couche de résine colorée (32) et de ladite seconde couche de résine colorée (33) présente une épaisseur de 5 à 50 µm.

9. Procédé selon la revendication 7 ou la revendication 8, dans lequel chacune de ladite première couche de résine colorée (32) et de ladite seconde couche de résine colorée (33) est supportée par un élément de support (B3, R3) avant d'être directement fixée sur ladite surface de ladite base réceptrice afin d'augmenter la résistance de chacune de ladite première couche de résine colorée (32) et de ladite seconde couche de résine colorée (33).

10. Procédé selon la revendication 7, 8 ou 9, dans lequel une surface dudit élément de support (B3, R3), qui doit venir en contact avec chacune de ladite première couche de résine colorée (32) et de ladite seconde couche de résine colorée (33) présente de bonnes propriétés de transmission de la lumière pour pouvoir exposer la couche photopolymérisée colorée au travers de celle-ci.
